(19) Europäisches Patentamt
European Patent Office
Office européen des brevets

(11) **EP 3 775 941 B1**

(12) **EUROPÄISCHE PATENTSCHRIFT**

(45) Veröffentlichungstag und Bekanntmachung des Hinweises auf die Patenterteilung:
**22.01.2025 Patentblatt 2025/04**

(21) Anmeldenummer: **18727754.6**

(22) Anmeldetag: **23.05.2018**

(51) Internationale Patentklassifikation (IPC):
**G01R 19/165** *(2006.01)* **G01R 29/08** *(2006.01)*

(52) Gemeinsame Patentklassifikation (CPC):
**G01R 19/16509; G01R 29/0842**

(86) Internationale Anmeldenummer:
**PCT/EP2018/063426**

(87) Internationale Veröffentlichungsnummer:
**WO 2019/185172 (03.10.2019 Gazette 2019/40)**

(54) **VORRICHTUNG ZUR ERFASSUNG ELEKTRISCHER STRÖME AN ODER IN DER NÄHE ELEKTRISCHER LEITER**

DEVICE FOR DETECTING ELECTRICAL CURRENTS ON OR IN THE VICINITY OF ELECTRICAL CONDUCTORS

DISPOSITIF DE DÉTECTION DE COURANTS ÉLECTRIQUES AU NIVEAU OU AU VOISINAGE D'UN CONDUCTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.03.2018 DE 102018107481**
**11.05.2018 DE 102018111308**

(43) Veröffentlichungstag der Anmeldung:
**17.02.2021 Patentblatt 2021/07**

(73) Patentinhaber: **DEHN SE**
**92318 Neumarkt i.d. OPf. (DE)**

(72) Erfinder:
• **ZAHLMANN, Peter**
**92318 Neumarkt (DE)**
• **BIRKL, Josef**
**92334 Berching (DE)**
• **BÖHM, Thomas**
**92366 Hohenfels (DE)**
• **BÜHLER, Klaus**
**90542 Eckental (DE)**
• **MAGET, Johannes**
**92331 Parsberg (DE)**
• **EHRHARDT, Arnd**
**92318 Neumarkt/Opf. (DE)**
• **SHULZHENKO, Eduard**
**98693 Ilmenau (DE)**

(74) Vertreter: **Prinz & Partner mbB**
**Patent- und Rechtsanwälte**
**Rundfunkplatz 2**
**80335 München (DE)**

(56) Entgegenhaltungen:
WO-A1-2017/036793    DE-A1- 10 329 223
DE-A1- 102010 038 856    DE-A1- 19 733 268
DE-A1- 4 430 382    RU-C1- 2 554 282

**Beschreibung**

Die Erfindung betrifft eine Vorrichtung zur Erfassung elektrischer Ströme an oder in der Nähe elektrischer Leiter mit mindestens einem Reed-Kontakt als magnetisch ansprechender Schalter, welcher so in der Nähe des elektrischen Leiters angeordnet ist, dass bei einem signifikanten Stromfluss durch den Leiter das entstehende magnetische Feld den Schalter auslöst und eine mit dem Schalter in Verbindung stehende Auswerteelektronik anstößt gemäß Anspruch 1 sowie eine Verwendung einer derartigen Vorrichtung zur Erfassung und Klassifizierung von Blitz- und Überstromereignissen gemäß Anspruch 14.

Aus der DE 2 826 247 C2 ist ein Kurzschlussanzeiger für elektrische Leitungen vorbekannt.

Der Kurzschlussanzeiger weist einen vom Magnetfeld einer elektrischen Leitung gesteuerten Reed-Kontakt und eine elektronische Selbsthalteschaltung auf. Die Selbsthalteschaltung ist als Flip-Flop-Schaltung ausgebildet, die sowohl ein elektronisches Zählwerk als auch einen Taktgenerator steuert. Der Taktgenerator stößt einen Blinksignalgeber an. Das elektronische Zählwerk stellt nach Zeitablauf die Flip-Flop-Schaltung zurück und stoppt den Taktgenerator.

Der eingesetzte Reed-Kontakt ist in einer zum Stromleiter parallelen Ebene angeordnet derart, dass im Augenblick eines Kurzschlusses ein entsprechend großes Magnetfeld erzeugt wird, welches auf den Reed-Kontakt einwirkt und diesen zumindest kurzzeitig schließt.

Damit gelangt eine Versorgungsspannung auf den Eingang der Flip-Flop-Schaltung, so dass diese in die Selbsthaltestellung übergeht.

Durch Verdrehung des Reed-Kontaktes um die gedachte Längsachse eines Gehäuses ist dessen Empfindlichkeit verringert. Hierdurch kann werkseitig der Kurzschlussanzeiger auf bestimmte abgestufte Auslöseströme zum Beispiel im Bereich von 200 - 400 A eingestellt werden.

Die DE 103 29 223 B9 offenbart einen Kurzschlussstromsensor, der die Kraft des Magnetfeldes eines Kurzschlussstromes nutzt, um einen Reed-Kontakt zu schließen, der derart auf einer Leiterplatte montiert ist, dass dieser durch eine Drehung zwischen 0 und 90° auf einen bestimmten Auslösestrom einstellbar ist.

Die DE 27 00 995 A1 betrifft ein Überwachungssystem für einen elektrischen, stromdurchflossenen Verbraucher.

Bei dem Verbraucher handelt es sich insbesondere um Brems- oder Schlussleuchten von Kraftfahrzeugen. In dem durch die Zuleitung des Verbrauchers fließenden Strom erzeugten Magnetfeld wird ein magnetfeldabhängiger Schalter angeordnet, der zu einer Anzeigeeinrichtung führt. Als Schalter kommt insbesondere ein Reed-Kontakt zum Einsatz.

Bei einer bevorzugten Ausführungsform ist der Schalter im Inneren einer von der Verbraucherzuleitung gebildeten Spule angeordnet, so dass sich das jeden einzelnen Leiter umgebende Magnetfeld der benachbarten Spulenwindungen überlagert, um eine ausreichende Ansprechempfindlichkeit zu erhalten.

In einer Ausbildung der dortigen Lehre ist die Spule und der magnetfeldabhängig betätigbare Schalter als Baueinheit zusammengefasst, welche in die Zuleitung des Verbrauchers einschleifbar ist.

Bei der Anordnung zur selektiven Auslösung von hintereinander geschalteten, selektiv gestarteten Schutzschaltern, in der ein vom Kurzschluss direkt betroffener Schutzschalter ein Blockiersignal an ein Auslösesystem ausgibt gemäß DE 199 30 089 A1 ist mit jeder Hauptstrombahn eines nachgeschalteten Schutzschalters ein Schutzrohrkontakt magnetisch gekoppelt und elektrisch mit dem Auslösesystem des vorgeordneten Schutzschalters verbunden.

Bevorzugt ist der Schutzrohrkontakt in der Nähe einer Anschlussklemme des Schutzschalters angeordnet.

Die DE 197 33 268 A1 beschreibt ein Verfahren zum Detektieren von Über- und Kurzschlussströmen in Leitern einer Mittel- oder Hochspannungsanlage sowie eine Einrichtung zum Durchführen des Verfahrens. Die Einrichtung verfügt über je einen Reed Kontakt pro Leiter der Anlage, welche bei Auftreten eines durch einen Über- oder Kurzschlussstrom erzeugten Magnetfelds auslösen und auf diese Weise einen Impuls in der Einrichtung erzeugen.

Aus der WO 2017/036793 ist ein Verfahren zur Erfassung von Blitzstromparametern an Anlagen mit mehreren Fangeinrichtungen und Blitzstromableitpfaden bekannt. Dazu werden zwei verschiedene Arten von Blitzstromsensoren eingesetzt, wobei ein einfacher Blitzstromerfassungssensor für jede der Fangeinrichtungen vorgesehen ist, der lediglich eine Ja/Nein-Aussage zum Blitzstromereignis liefert, während ein zentraler Blitzstrommesssensor zum Unterscheiden von Stoßströmen und Langzeitströmen eingesetzt wird.

Die DE 10 2010 038 856 A1 zeigt einen passiven Magnetschalter mit zumindest zwei Reed-Kontakten, die sich in unterschiedliche Erstreckungsrichtungen erstrecken, sodass deren Kontaktzungen zum Öffnen und Schließen des jeweiligen Reed-Kontakts in unterschiedliche Bewegungsrichtungen bewegbar sind. Der Magnetschalter dient zur Detektion von auftretenden Magnetfeldern in beliebigen Raumrichtungen, beispielsweise im Einflussbereich eines Magnetresonanztomographen.

Die DE 44 30 382 A1 beschreibt ein elektromechanisches Schaltgerät mit einer Kombination von Differential-Halleffekt-Sensoren, einem Reed-Sensor und einem Verschweißsensor.

Die RU 2 544 282 C1 offenbart ein Verfahren zum Erfassen von elektrischen Strömen in einem elektrischen Leiter sowie eine Vorrichtung dafür. Die Vorrichtung umfasst eine Vielzahl von Reed-Kontakten, die in jeweils unterschiedlichem Abstand zum elektrischen Leiter angeordnet und mit einem Mikrocontroller verbunden sind. Die Reed-Kontakte sind derart angeordnet, dass sie mit zunehmendem Abstand erst bei stetig größerem Stromfluss durch den elektrischen Leiter ansprechen. Aus den Zeitpunkten, zu denen die Reed-Kontakte auslösen (und sich nach Abklingen des Stroms wieder öffnen) wird ein Polynom ermittelt, welches den Stromverlauf näherungsweise beschreibt. Das Polynom wird anschließend genutzt, um die Amplitude des detektierten Stroms zu ermitteln.

Den vorstehend geschilderten Lösungen des Standes der Technik ist gemeinsam, dass ein Reed-Kontakt die Basis eines Schalters bildet, wobei der Schalter durch ein Magnetfeld betätigbar ist. Bei ausreichender magnetischer Energie gelangen die Kontaktzungen eines an sich bekannten Reed-Schalters in eine kontaktschließende Position mit der Folge, dass der Stromkreis, in welchem der Schalter befindlich ist, geschlossen wird. Auf der Basis der Nutzung derartiger Reed-Schalter können Stromkreise überwacht und deren Funktion signalisiert werden. Darüber hinaus kann ein Kurzschlussstrom festgestellt werden, indem der Kurzschlussstrom selbst als Schwellwert definiert wird, dessen Magnetfeld in der Lage ist, den Reed-Kontakt, das heißt den Schalter, zu schließen.

Aus dem Vorgenannten ist es Aufgabe der Erfindung, eine weitergebildete, nur einen geringen Bauraum einnehmende Vorrichtung zur Erfassung elektrischer Ströme an oder in der Nähe elektrischer Leiter mit mindestens einem Reed-Kontakt als magnetisch ansprechender Schalter anzugeben, wobei die Vorrichtung nicht nur in der Lage ist, einen Schaltzustand mit Erreichen eines bestimmten Stromflusses im elektrischen Leiter zu definieren, sondern ebenso die Möglichkeit besteht, Stromimpulse und damit Stoßströme zu erfassen und diese zu bewerten, ohne dass ähnlich wie bei sogenannten Blitzzählern aufwändige elektronische und damit teure und störanfällige Schaltungen erforderlich sind.

Die Lösung der Aufgabe der Erfindung erfolgt mit einer Vorrichtung gemäß der Merkmalskombination nach Anspruch 1 sowie der erfindungsgemäßen Verwendung gemäß der Lehre nach Anspruch 14, wobei die Unteransprüche mindestens zweckmäßige Ausgestaltungen und Weiterbildungen darstellen.

Im Ergebnis umfangreicher Untersuchungen hat sich in überraschender Weise herausgestellt, dass mit einer quasi räumlich gestaffelten, bezogen auf einen elektrischen Leiter beabstandeten und/oder in ihrer Empfindlichkeit gestaffelten Anordnung von mehreren Reed-Kontakten Stoßstromgrößen ermittelt und unterschieden werden können. Dabei hat sich in besonders überraschender Weise gezeigt, dass nicht nur Langzeitimpulsströme erkennbar sind, sondern auch Kurzzeitimpulsströme bewertet werden können. Die erfindungsgemäße Vorrichtung arbeitet dabei auch in rauer Umgebung und unter Einfluss mechanischer Erschütterungen und Schwingungen störungsfrei, was wiederum bezogen auf bestimmte Applikationen, zum Beispiel der Überwachung von Blitzeinschlägen in Windkraftanlagen überraschend ist.

An sich besitzen Reed-Kontakte aufgrund ihres Aufbaus eine mechanische Trägheit, welche das reproduzierbare Ansprechen bei extrem kurzzeitigen Impulsbelastungen nicht erwarten lässt. Das ermittelte definierte Ansprechen der empfindlichen Kontakte, teilweise bereits während des Impulsvorganges, ist ebenso wenig vorhersehbar, wie das ebenfalls reproduzierbare Ansprechen von Kontakten mit geringerer Empfindlichkeit bzw. höherer mechanischer Trägheit noch deutlich nach der Impulsbelastung ohne weiter einwirkendes magnetisches Feld. Weiterhin überrascht die Überlastfestigkeit, insbesondere der empfindlichen Reed-Kontakte. Es können sowohl Impulsströme von < 100 A aber auch kleine Langzeitströme sicher erfasst werden. Bei deutlich größeren Impulsbelastungen bis hin zu 250 kA mit magnetischen Feldbelastungen, welche um den Faktor 1000 oder größer oberhalb der Ansprechspannung liegen, werden die mechanischen Komponenten des jeweiligen Reed-Kontaktes durch die hohen dynamischen Kräfte nicht mechanisch zerstört oder beschädigt, so dass selbst nach derartigen Mehrfachbelastungen eine reproduzierbare Erfassung von Impulsströmen möglich ist.

Durch eine erfindungsgemäße Positionierung des jeweiligen Reed-Kontaktes und eine nahezu schleifenfreie Zuführung der Anschlüsse kann eine nachteilige Einkopplung von Strömen in dem Pfad der Kontakte so weit reduziert werden, dass die notwendigen empfindlichen Kontakte mit sehr geringen Schaltströmen durch die induzierten Ströme beim Schließen nebst gegebenenfalls hochfrequentem Prellen durch die Vermeidung von Abrissfunken nicht geschädigt werden. Eine Funkenbildung kann durch zusätzliche Beschaltungen des Reed-Kontaktes vermieden werden. Eine unerwünschte Einkopplung von Strömen in die Anschlussschleife der Reed-Kontakte kann durch aktive bzw. passive Überspannungsschutzmaßnahmen reduziert werden.

Die erfindungsgemäße Vorrichtung zur Erfassung elektrischer Ströme unter Nutzung von Reed-Kontakten kann in eine sogenannte intelligente Fangstange integriert werden oder einen Bestandteil einer solchen Fangstange darstellen, um Blitzereignisse bewerten zu können.

Gemäß einem weiteren Applikationsbeispiel kann die erfindungsgemäße Vorrichtung zur Erfassung von Strömen in solchen Leitern genutzt werden, die Bestandteil einer baulichen Anlage sind und welche entsprechend EN 62305-3 als Ableitungseinrichtung genutzt werden. Die Reed-Kontakte können auch an bzw. in der Nähe elektrisch leitfähiger Bauteile installiert werden, welche prinzipiell nicht für den Blitzschutz vorgesehen sind, über die aber ein Blitzteilstrom fließen kann. Beispielhaft sei hierzu auf Förderseile von Seilbahnen, Halteseile von Kränen oder dergleichen verwiesen. Diesbezüglich gelingt es, frühzeitig eine mögliche Schädigung durch Blitzteilströme an solchen Seilen zu erkennen, um geeignete Maßnahmen, zum Beispiel Austausch geschädigter Seile in die Wege zu leiten.

Die durch einen Einsatz der Reed-Kontakte sich ergebende galvanische Trennung und den Abstand der Vorrichtung mit ihren elektronischen Komponenten von der blitzstromdurchflossenen Ableitung ist ein störungsfreier Betrieb über einen langen Zeitraum ohne Wartungsaufwand möglich.

Ebenso kann die erfindungsgemäße Vorrichtung Bestandteil von Überspannungsableitern sein oder zur Bewertung der Belastung von Überspannungsableitern herangezogen werden, indem nämlich die erfindungsgemäße Vorrichtung in den betreffenden Strompfad integriert, respektive diesem zugeordnet wird.

Damit stellt die erfindungsgemäße Vorrichtung eine kostengünstige Alternative zu ansonsten zum Einsatz kommenden aufwändigen Messsystemen, zum Beispiel unter Nutzung von sogenannten Rogowski-Spulen dar.

Die erfindungsgemäße Vorrichtung ermöglicht bei ihrer Anwendung das Erreichen einer Doppelfunktion, indem einerseits Störstromimpulse, zum Beispiel auf der Basis von Blitzereignissen erfasst werden und diese hinsichtlich der Impulsform und Impulsdauer aber auch der Stromhöhe unterscheidbar sind.

Die Vorrichtung zur Erfassung elektrischer Ströme an oder in der Nähe elektrischer Leiter geht demnach von einem Reed-Kontakt als magnetisch ansprechenden Schalter aus, welcher so in der Nähe des elektrischen Leiters angeordnet ist, dass bei einem signifikanten Stromfluss durch den Leiter das entstehende magnetische Feld den Schalter auslöst und eine mit dem Schalter in Verbindung stehende Auslöseelektronik anstößt.

Erfindungsgemäß wird für eine Detektion von Stoßstromgrößen und Unterscheidung von Langzeitimpulsströmen einerseits und Kurzzeitimpulsströmen andererseits eine Vielzahl von Reed-Kontakten in vorgegebenem Abstand zum elektrischen Leiter angeordnet.

Weiterhin wird erfindungsgemäß für die Einstellung des Ansprechverhaltens wenigstens einer der Reed-Kontakte mit einer Schirmung zur Beeinflussung des auf den jeweiligen Reed-Kontakt einwirkenden magnetischen Feldes versehen.

Die Auswerteelektronik ermittelt das Ansprechen und die Schaltzeiten der jeweiligen Reed-Kontakte. Aus der Zuordnung der ermittelten Werte zu dem Reed-Kontakt, respektive dessen räumlicher Anordnung und dem Abstand zum elektrischen Leiter lässt sich die Stoßstromgröße und aus der Schaltzeit die Impulsform, bevorzugt unter Einsatz eines Mikrocontrollers ermitteln oder bestimmen.

Erfindungsgemäß können nicht nur Reed-Kontakte mit Schließerfunktion eingesetzt werden. Ebenso besteht die Möglichkeit, öffnende Reed-Kontakte zu nutzen. Entsprechende öffnende Kontakte können in Verbindung mit einem Permanentmagneten so realisiert werden, dass das Ansprechverhalten des Kontaktes einstellbar ist.

Es liegt daher im Sinne der Erfindung, das Ansprechverhalten bezogen auf die Unterscheidung der Ströme nicht nur durch eine räumlich beabstandete Ausbildung einzustellen, sondern auch auf weitere Kriterien zurückzugreifen. Zur Einstellung von Grenzen des Ansprechverhaltens der jeweiligen Reed-Kontakte wird die o.g. Schirmung vorgeschlagen. Diese Schirmung kann als metallische Hülse oder metallische Schicht ausgeführt werden. Gegen hochfrequente Vorgänge sind beispielsweise metallische Hülsen oder Schichten zur Erzeugung von Wirbelströmen auf der Basis von Kupfer oder Alumaterialien zweckmäßig. Zur Reduzierung der Empfindlichkeit bei niederfrequenten Vorgängen können Materialien mit hoher Permeabilität, zum Beispiel weichmagnetische Stähle eingesetzt werden.

Zur Nutzung beider Effekte sind Materialien mit hoher Permeabilität zusätzlich mit elektrisch leitfähigen Beschichtungen, zum Beispiel aus Kupfer einsetzbar. Aufgrund der Sättigung von Materialien mit hoher Permeabilität bei starken Magnetfeldern ist eine Staffelung der Schirmmaterialien, welche den jeweiligen Reed-Kontakt umgeben, vorteilhaft.

Durch die Schirmung kann also die Empfindlichkeit der Reed-Kontakte individuell eingestellt und verändert werden, so dass letztendlich die Verwendung von Standard-Reed-Kontakten mit gleicher Empfindlichkeit und gleicher Bauform möglich wird.

Aufgrund der Grenzen unterschiedlicher räumlicher Beabstandung der Reed-Kontakte zum elektrischen Leiter können alternativ oder ergänzend öffnende Kontakte gleicher Bauart mit unterschiedlichen Gegenfeldmagneten verwendet werden. Ebenso ist der Einsatz von Schließern möglich, welche neben der Distanz zusätzlich gegen die Einwirkung von Magnetfeldern geschirmt sind.

In einer Ausführungsform der Erfindung ist der elektrische Leiter Bestandteil einer Blitzstromableitung, einer Fangstange oder eines leitfähigen Bauteiles, über das prinzipiell ein Blitzstrom fließen kann.

In einer weiteren Ausführungsform der Erfindung ist der elektrische Leiter Bestandteil eines stoßstromführenden Überspannungsableiters.

Die Auswerteelektronik weist neben dem bevorzugten Mikrocontroller auch einen Datenspeicher auf.

Die gespeicherten Daten können drahtlos oder drahtgebunden bzw. mittels Faseroptik (LWL) an eine übergeordnete Einheit zur Langzeitanalyse von impulsförmigen Stoßströmen bzw. Langzeitströmen übergeben werden.

Hierdurch ist es möglich, beispielsweise durch Einbindung einer Vielzahl von erfindungsgemäßen Vorrichtungen in komplexen Gebäuden, Belastungen bezüglich von Überstromereignissen zu erfassen, zu speichern und zur Standortoder Gefahrenanalyse auszuwerten.

Um einen dauerhaften, wartungsfreien Einsatz der Vorrichtung zu gewährleisten, ist diese mit einer Langzeitstromversorgung ausgerüstet.

Weil die erfindungsgemäße Vorrichtung sich üblicherweise in einem sogenannten Sleep-Modus befindet und erst beim Auftreten von Überstromereignissen aktiviert wird, treten nur äußerst geringe Ruheströme auf, welche zu gewünschten langen Einsatzzeiten ohne Wechsel einer Batterie bzw. eines Akkumulators führen.

In einer Ausgestaltung der Erfindung kann die erfindungsgemäße Vorrichtung auch Energie aus dem Netz ziehen, mit welchem der stromdurchflossene Leiter üblicherweise verbunden ist.

Die erforderliche Energie zur Impulsregistrierung bzw. zum Betrieb der Auswerteschaltung kann aus dem eigentlichen Stör- bzw. Messsignal, das heißt aus dem Impuls selbst gewonnen werden.

Eine alternative Möglichkeit zur Betriebsenergiegewinnung ist das sogenannte Energy Harvesting. Hierbei kann eine Energieerzeugung aus einer Bewegung oder aber auch unter Rückgriff auf photovoltaische Elemente realisiert werden.

In Weiterbildung der Erfindung weist die Vorrichtung ein Funkmodul zur Datenübertragung auf, wobei die Datenübertragung erfindungsgemäß erst nach Ablauf einer vorbestimmten Zeitspanne nach Abklingen des letzten Stoßstromimpulses ausgelöst wird. Auf diese Weise wird eine störungsfreie Datenübertragung gewährleistet.

In einer Ausführungsform der Erfindung sind mindestens die Reed-Kontakte auf einem flächigen Verdrahtungsträger, beispielsweise einer kupferbeschichteten Leiterplatte fixiert.

In einer bevorzugten Ausbildung der Erfindung ist die Winkellage der Gruppen von Reed-Kontakten bezogen auf den elektrischen Leiter fest vorgegeben und nicht variabel, um reproduzierbare Messergebnisse zu erreichen.

Weiterhin ist erfindungsgemäß ein die Komponenten der Vorrichtung aufnehmendes Gehäuse ausgebildet, welches eine Stirn- oder Seitenfläche besitzt, die mit Mitteln zur Kennzeichnung der Lage und/oder zur Befestigung des elektrischen Leiters versehen ist.

Auf diese Weise wird beim Einsatz bzw. der Montage der Vorrichtung an oder in der Nähe eines elektrischen Leiters für eine korrekte Zuordnung zwischen dem sich bei Stromfluss ausbildenden Feld um den Leiter und den im Gehäuse befindlichen Reed-Kontakten gewährleistet.

Dadurch, dass das Gehäuse keine Öffnungen zur Aufnahme oder Durchführung des elektrischen Leiters aufweisen muss, kann selbiges auf höchste Schutzgrade, das heißt zum Einsatz im Freien und unter kritischen Umweltbedingungen ausgelegt werden.

In einer besonderen Variante der erfindungsgemäßen Vorrichtung ist diese so ausgelegt, dass eine Anordnung an oder in der Nähe von Blitzableiterseilen von Rotorblättern in Windkraftanlagen erfolgt. Mittels einer nachgeordneten Zähleinrichtung kann die Anzahl, aber auch die Stärke und die Impulsform von Blitzstromereignissen erfasst werden, um hieraus zu schlussfolgern, ob womöglich die an der Oberfläche von Rotorblättern von Windkraftanlagen befindlichen sogenannten Rezeptoren bereits übermäßig belastet bzw. aufgeschmolzen sind, so dass ein Wartungseinsatz bzw. eine Reparatur planmäßig einordenbar ist.

Die erfindungsgemäße Vorrichtung kann auch zur Überwachung und Bewertung von möglichen Blitzeinschlägen in Förderseilen, zum Beispiel von Seilbahnen, genutzt werden. Die Erfassung der Blitzströme in den Förderseilen wird durch entsprechend angeordnete und ausgelegte Sensoren mit Reed-Kontakten im Sinne der erläuterten Lehre realisiert. Wenn Blitzströme oder Blitzteilströme erfasst wurden, erfolgt eine Meldung an eine übergeordnete Kontrolleinrichtung. Hieraus kann dann auf die Notwendigkeit einer Kontrolle des Förderseiles geschlossen werden und gegebenenfalls eine Betriebsunterbrechung anzuordnen sein. Besonders problematisch bei derartigen Anwendungen ist die Detektion von Langzeitströmen. Langzeitströme sind wesentlich für auftretende Ausschmelzungen am Förderseil, die vor allem bei Wintergewittern möglich sind.

Die vorgeschlagene energieautarke Arbeitsweise der erfindungsgemäßen Erfassungsvorrichtung ohne galvanische Anbindung an ein Versorgungsnetz hat den Vorteil, dass keine Trennungsabstände zur Messeinrichtung einzuhalten sind.

Die erfindungsgemäße Verwendung der vorgestellten Vorrichtung zielt auf die Erfassung und Klassifizierung von Blitz- und Überstromereignissen, auch solchen, die nicht blitzstoßstrombedingt sind, jedoch einen Stoßstromcharakter aufweisen im Bereich von > 50 A bis hin zu 200 kA und auf eine Erfassung von Ereignissen der Impulsformen als Langzeitimpuls mit T $\geq$ 10 ms sowie Impulsformen derart 10/350 $\mu$s und 8/20 $\mu$s.

Die Erfindung soll nachstehend anhand eines Ausführungsbeispieles sowie von Figuren näher erläutert werden.

Die Figur 1 zeigt hierbei eine Prinzipanordnung der erfindungsgemäßen Vorrichtung mit beispielsweise drei Reed-Kontakten in einem definierten Abstand zum elektrischen Leiter.

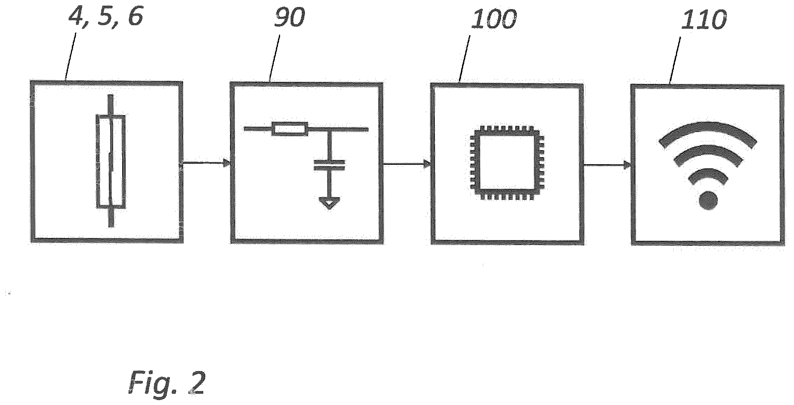

Die Figur 2 zeigt ein vereinfachtes Blockschaltbild der Auswerteelektronik mit einem dem jeweiligen Reed-Sensor 4; 5; 6 nachgeordnetem Tiefpassfilter 90, dessen jeweiliger Ausgang auf einen Mikrocontroller 100 führt, welcher ausgangsseitig mit einer Funkschnittstelle 110 in Verbindung steht.

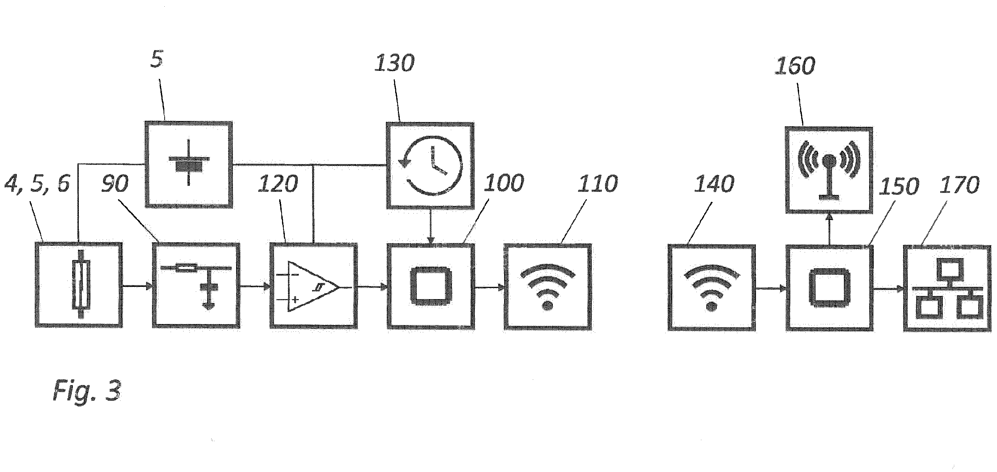

Bei dem Blockschaltbild gemäß Figur 3 wird wiederum von Reed-Sensoren 4; 5; 6 ausgegangen, die mit einem R-C-Tiefpassfilter 90 in Verbindung stehen.

Zur Ermittlung der Schaltzeit des jeweiligen Reed-Sensors 4; 5; 6 stehen die Tiefpassfilter jeweils mit dem Eingang eines Komparators 120 in Verbindung, dessen Ausgang auf den Mikrocontroller 100 nebst Speichereinheit führt.

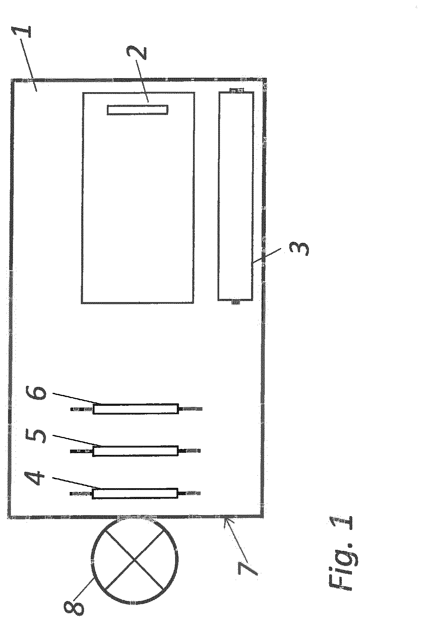

Diesbezüglich ist ein Zeitbaustein 130 vorhanden, der auf den Vergleichseingang des Komparators 120 führt. Zur Spannungsversorgung wird die zur Figur 1 bereits erläuterte Batterie 5 eingesetzt. Mit Hilfe des Zeitbausteines 130 und dem Mikrocontroller 100 lässt sich signalverarbeitungstechnisch aus der Schaltzeit des jeweiligen Reed-Sensors oder Reed-Kontaktes 4; 5; 6 die erfasste Impulsform bestimmen.

Die Baugruppen 110 und 140 bilden eine Luftschnittstelle und gewährleisten eine drahtlose Datenübertragung der detektierten Stoßstromgrößen.

Eine weitere Signalverarbeitungs- und Steuereinheit 150 steht mit einem Kommunikationsbaustein 160 in Verbindung, um über GSM eine Cloud-Anbindung zu gewährleisten. Alternativ kann mit Hilfe des Bausteines 170 eine klassische Internetanbindung zur Datenauswertung sowie zur Langzeitanalyse realisiert werden.

Die Vorrichtung gemäß Ausführungsbeispiel nach Figur 1 geht von einer Leiterplatte 1 aus, welche eine Auswerteeinheit mit Funkmodul 2 sowie eine langzeitstabile Stromversorgung in Form einer Batterie 3 aufweist.

An bzw. auf einem flächigen Seitenabschnitt der Leiterplatte 1 bzw. Verdrahtungsträgers sind drei beabstandete Reed-Kontakte 4, 5 und 6 angeordnet, die sich im Wesentlichen parallel zueinander befinden. Zur Einstellung des Ansprechverhaltens kann mindestens einer der Reed-Kontakte eine Schirmung aufweisen.

An einer quasi Anschlagkante 7 der Leiterplatte 1 wird ein elektrischer Leiter 8 herangeführt. Hier kann es sich beispielsweise um ein Ableiterseil eines Rotors einer Windkraftanlage handeln.

Wird das Ableiterseil 8 von einem Stoßstrom durchflossen, bildet sich um das Ableiterseil ein magnetisches Feld aus, welches die beabstandeten Reed-Kontakte 4, 5, 6 in unterschiedlicher Stärke durchdringt.

Beispielsweise wird davon ausgegangen, dass der Reed-Kontakt 4 einen Abstand von 5 mm zum Leiter inne hat, der Reed-Kontakt 5 einen Abstand zum Leiter von 15 mm und der Reed-Kontakt 6 einen Abstand vom Leiter von 105 mm aufweist.

Der Reed-Kontakt 4 ist in der Lage, Langzeitimpulse mit einem $Imin \geq 50$ A und einer Impulsdauer von $T \geq 10$ ms zu erfassen. Ebenso kann der im engsten Abstand zum Ableiterseil 8 stehende Reed-Kontakt 4 Stoßstromimpulse der Impulsform 10/350 $\mu$s mit $Imin \geq 60$ A und Stoßstromimpulse der Impulsform 8/20 $\mu$s mit $Imin \geq 70$ A detektieren.

Der Reed-Kontakt 5 ist in der Lage, Impulsströme der Impulsform 10/350 $\mu$s mit $Imin \geq 200$ A und Impulsströme 8/20 $\mu$s mit $Imin \geq 750$ A zu detektieren.

Das im Abstand von ca. 105 mm vom Ableiterseil 8 befindliche Reed-Kontakt-Relais 6 ist in der Lage, Impulse der Impulsform 10/350 $\mu$s mit $Imin \geq 4,5$ kA und Impulse der Impulsform 8/20 $\mu$m mit $Imin \geq 67$ kA zu erfassen.

Mit Hilfe der in der Vorrichtung integrierten Auswerteelektronik können die unterschiedlichen Schaltzeiten der Reed-Kontakte je nach Impulsform erfasst und ausgewertet werden, so dass erkennbar ist, um welche Impulsformen mit welcher Impulsdauer es sich handelt.

Gleichfalls kann durch das selektive Ansprechen der Reed-Kontakte bei entsprechenden Stoßströmen eine Unterscheidung im Bereich von etwa 60 A bis hin zu 250 kA vorgenommen werden.

Bei einem Blitz- oder Stoßstromereignis wird dieses zunächst durch Ansprechen mindestens eines Reed-Kontaktes erfasst. Hiernach erfolgt eine Unterscheidung der gemessenen Stromstärken durch das Ansprechverhalten der einzelnen Reed-Kontakte. Die erfassten Daten werden unter Beachtung des Zeitverlaufes bzw. des Zeitdeltas zu nachfolgenden Ereignissen gespeichert und stehen dann zur weiteren Auswertung zur Verfügung.

Mit einer im Prüffeld getesteten erfindungsgemäßen Vorrichtung liegt die erfassbare Minimalstromstärke bei etwa 45 A. Mit dem Einsatz von beispielsweise drei Reed-Kontakten können drei Impulsschwellen vorgegeben und bewertet werden. Bei einer entsprechenden Erweiterung des zur Auswertung eingesetzten Mikrocontrollers kann eine weitere Diversifizierung erfolgen, ohne das Grundprinzip der Erfindung zu verlassen.

Möglicherweise notwendig werdende Komponenten zur Langzeitspeicherung und Analyse der erfassten Werte können räumlich entfernt von der erfindungsgemäßen Vorrichtung in EMV-geschützten Räumlichkeiten angebracht werden. Dies ist möglich, da bevorzugt eine drahtlose Übertragung der durch die Vorrichtung bereitgestellten Messwerte zur nachgeordneten Auswerteeinheit erfolgt und diese Übertragung erst nach Abklingen des letzten Störereignisses auslösbar ist.

Durch eine fest eingestellte Verzugszeit zwischen auftretendem Blitzereignis und dem Senden des Ereignisprotokolls kann eine Millisekunden-genaue Zeitzuordnung bzw. ein Millisekunden-genauer Zeitstempel erreicht werden.

Folgende beispielhafte Auslöseschwellen der Reed-Kontakte ergaben sich nach durchgeführten Versuchen:

Tabelle 1: Auslöseschwellen der Reed-Kontakte

| Impulsform | reed 1 | reed2 | reed3 |
|---|---|---|---|
| 8/20 $\mu$s | 350 A | 1250 A | 67 kA |
| 10/350 $\mu$s | 140 A | 260 A | 4,5 kA |
| DC-Prüffeld | 141 A | - | - |

Die Auslöseschwellen der Reed-Kontakte können stark durch den Abstand und durch die Art der Kontakte variiert werden. Bei diesen Auslöseschwellen kann zwischen einem $I_{cc\ only}$ und einem Kurzzeitimpuls unterschieden werden. Falls der 3. Reed-Kontakt bei einer höheren Stromstärke auslösen soll, kann der Abstand noch vergrößert werden. Bei den verschiedenen Ableitseilen (95 mm², Ø = 11 mm, Isolierwandstärke = 2,5 mm, 50 mm², Ø = 8 mm, Isolierwandstärke = 2,5 mm) konnte eine Abweichung der Auslöseschwelle von 10 A beobachtet werden. Bei 10/350 Impulsen liegt die Auslöseschwelle im Vergleich zu 8/20 Impulsen deutlich niedriger.

Unter anderem lässt sich folgende Abhängigkeit des Ansprechens ab einem gewissen Abstand zum Ableitseil zwischen den Auslöseschwellen der ungeschirmten Reed-Kontakte der 8/20 und 10/350 μs-Impulse erkennen.

$$\frac{\int \left(I_{8/20}(t)\right)^2 dt}{\int \left(I_{10/350}(t)\right)^2 dt} \approx 15$$

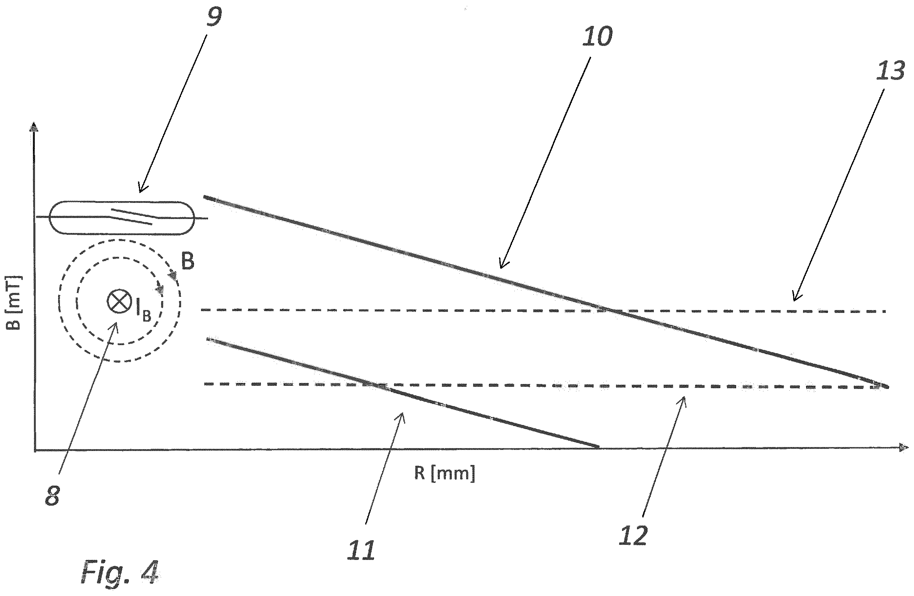

Gemäß der Figur 4 wird skizzenhaft ein stromdurchflossenes Seil oder ein Leiter 8 mit den umgebenden magnetischen Feldlinien B dargestellt. Der entsprechende Reed-Kontakt 9 ist radial so zum Magnetfeld des Leiters 8 ausgerichtet, dass seine Anschlüsse und Kontakte der magnetischen Flussdichte B ausgesetzt sind. Wird die Ansprechflussdichte bzw. die magnetische Empfindlichkeit des Reed-Kontaktes 9 erreicht, so schließen sich die Kontakte.

Das Erreichen der Ansprechflussdichte des Reed-Kontaktes 9 hängt dabei von der Stromstärke im Seil 8, vom Abstand des Reed-Kontaktes 9, der Empfindlichkeit des Reed-Kontaktes 9 und der Ausrichtung des Reed-Kontaktes 9 zum Leiterseil 8 ab.

Zudem kann das Ansprechverhalten durch die Beeinflussung des magnetischen Flusses B, beispielsweise das Einbringen von Materialien höherer Permeabilität verändert werden.

In der Figur 4 wird die Höhe der magnetischen Flussdichte in Abhängigkeit der Distanz R zur Mittelachse des Leiterseiles 8 prinzipiell gezeigt. Die dargestellten Achsen sind logarithmisch zu verstehen. Die minimale Distanz des Reed-Kontaktes 9 wird hierbei durch die Geometrie des Leiters 8 und die notwendige gegebenenfalls isolierte Befestigung begrenzt. In Figur 4 stellt die Linie 10 die magnetische Flussdichte für eine hohe Stromstärke und die Linie 11 für eine niedrigere Stromstärke dar. Die Linie 13 kennzeichnet die Ansprechschwelle eines Reed-Kontaktes 9 mit geringer Empfindlichkeit und die Linie 12 eines empfindlichen Reed-Kontaktes 9.

Bei einem kleinen Stromfluss und entsprechend geringer magnetischer Flussdichte 11 durch das Leiterseil 8 wird die Ansprechschwelle eines Reed-Kontaktes 9 mit geringer Empfindlichkeit 13 auch bei minimalstem technisch zu realisierenden Abstand des Reed-Kontaktes 9 zum Leiterseil 8 nicht erreicht. Eine Detektion des Stromes erfolgt unter diesen Umständen nicht. Um dennoch mit einem derartigen Reed-Kontakt 9 eine Detektion zu bewirken, ist es möglich, die Konzentration der magnetischen Feldlinien, beispielsweise durch ferromagnetische Stoffe, welche das Leiterseil 8 in gewissen Bereichen koaxial umgeben und mit den Anschlüssen des Reed-Kontaktes verbunden sind, zu erhöhen.

Eine solche Anordnung kann jedoch aufwändig sein und gegebenenfalls durch den Einsatz eines empfindlicheren Reed-Kontaktes (Linie 12) vermieden werden. Ein solcher Kontakt kann den entsprechenden Strom bzw. dessen magnetische Flussdichte noch in einigen Millimetern bzw. Zentimetern Abstand detektieren. Erst bei größeren Abständen oder Distanzen unterschreitet die magnetische Flussdichte des Stromes (Linie 11) die Empfindlichkeit eines entsprechenden Reed-Kontaktes (Linie 12), wodurch gegebenenfalls keine Erfassung mehr möglich ist.

Bei einem hohen Strom hingegen liegt die magnetische Flussdichte (Linie 10) bis zu einer großen Distanz weit oberhalb der hohen Empfindlichkeit des Reed-Kontaktes (Linie 12). Derartige Distanzen sind für eine technische Anwendung aufgrund der begrenzten Gerätegröße oftmals nicht umsetzbar.

Die Bandbreite der Empfindlichkeit von verfügbaren Reed-Kontakten ist begrenzt. Nachteilig ist zudem, dass die Reaktionszeit der Reed-Kontakte mit zunehmender Unempfindlichkeit im Allgemeinen steigt, so dass die gewünschte Detektion von kurzzeitigen Impulsströmen nicht oder nur mit starken zeitlichen Verzögerungen möglich wird.

Die magnetische Flussdichte von Langzeitströmen von einigen 10 A und Impulsströmen von mehreren 100 kA unterscheiden sich jedoch sehr stark, so dass selbst bei unempfindlichen Sensoren bei gewünschten hohen Detektionsschwellwerten bei Blitzströmen die notwendigen Distanzen erheblich sind und bis zu mehreren Metern betragen können, wodurch sich Nutzungseinschränkungen ergeben.

Um hohe Stromschwellen für Impulsströme und insbesondere Blitzströme der Impulsform 10/350 μs in kompakten Geräten realisieren zu können, können die Sensoren mit einer vollständigen oder teilweisen Schirmung versehen werden. Für eine orientierte Empfindlichkeit können die Schirmungen auch Fenster besitzen. Die Schirmung besitzt also insofern eine Schwächung oder eine Ausnehmung, durch welche das Magnetfeld teilweise eindringen kann.

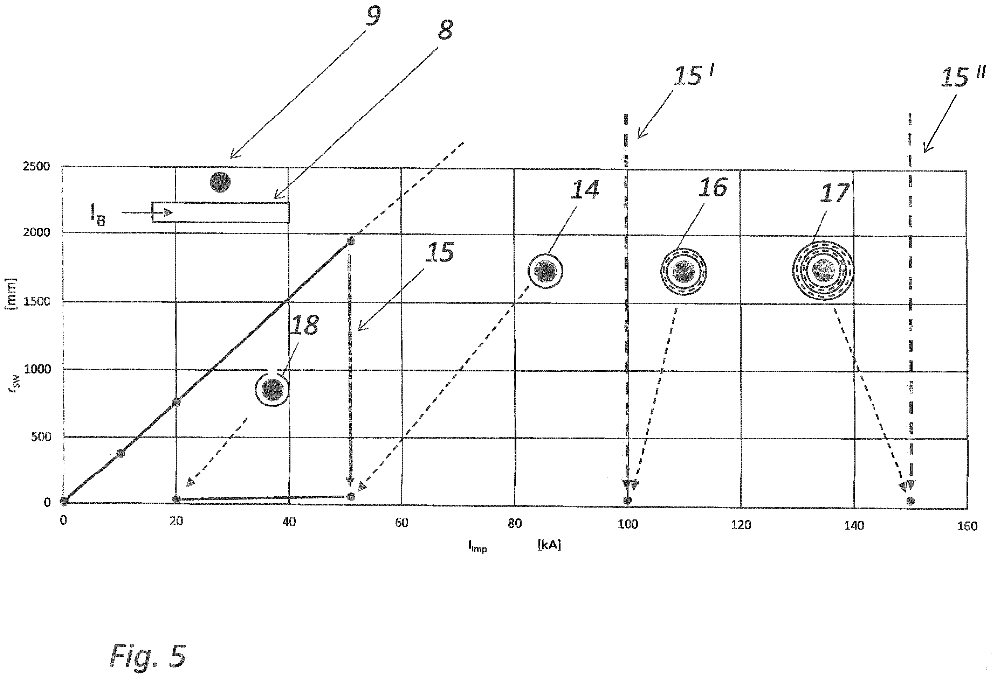

Gemäß Figur 5 wird die Funktionsweise der erwähnten Schirmung beispielhaft erläutert.

In der Darstellung ist der Abstand $r_{SW}$ des Sensors 9 zum Leiterseil 8 in Millimetern aufgetragen, bis zu welchem ein ungeschirmter Reed-Kontakt 9 mit einer Empfindlichkeit von ca. 15 AT in Abhängigkeit von der Höhe der Blitzströme sich noch schließt.

Aus einem experimentell ermittelten Verlauf mit eingetragenen Messpunkten (Grauton) für den ungeschirmten Reed-Kontakt 9 wird deutlich, dass bei gewünschten Schwellwerten von 200 kA oder höher der Reed-Kontakt in einer Distanz von mehreren Metern zum Leiterseil anzubringen wäre.

Es wird deutlich, dass bereits bei relativ geringen Blitzströmen von nur 20 kA eine erhebliche Distanz von ca. 75 cm einzuhalten wäre, wenn man das Überschreiten einer solchen Stromhöhe im Leiterseil 8 erfassen möchte.

Bei sehr hohen Stromschwellwerten ist daher eine kompakte, bzw. in einem Gehäuse konstruierte Messanordnung nur schwer realisierbar. Reed-Kontakte mit einer höheren Unempfindlichkeit verschieben diese Distanzen nur unwesentlich und beinhalten den Nachteil der zeitlichen Zuordnung des Schließens zum eigentlichen Stromereignis. Die Ausrichtung des Reed-Kontaktes in eine unempfindlichere Position zum Leiterseil ist von der Positionierung und Befestigung her sehr sensibel und stellt sehr hohe konstruktive Anforderungen an den Aufbau entsprechender Geräte und deren Anbringung.

Gemäß Figur 5 wird ein baugleicher Reed-Kontakt beispielsweise mit einem Stahlrohr mit einer Wandstärke im Bereich von einem bis wenigen Millimetern verwendet. Dies ist mit dem Bezugszeichen 14 vereinfacht dargestellt. Der Pfeil 15 zeigt die Wirkung dieser einfachen Anordnung bzw. des Abstandes, bei welcher die Stromquelle (Strom > 50 kA 10/350 $\mu$s) detektiert werden kann. Von ca. 2 m Abstand des ungeschirmten Reed-Kontaktes oder Sensors verschiebt sich die Distanz auf wenige Millimeter bzw. Zentimeter.

Bei noch höheren Impulsströmen kann anstelle einer einfachen Schirmung auch eine doppelte 16 bzw. dreifache Schirmung 17 verwendet werden.

Hierbei sind die Schirmungen z.B. und Stahlrohre durch isolierte Zwischenlagen bzw. Luft getrennt.

Bei diesen Beispielen wird bei gleichem Reed-Kontakt die Distanz zur Erfassung der Schwellwerte Strom > 100 kA bzw. > 150 kA aus einem Bereich von mehreren Metern auf wenige Zentimeter reduziert.

Es wird deutlich, dass sehr kompakte Geräte für die Erfassung von sehr unterschiedlichen Stromschwellen unter Nutzung des Gedankens der Schirmung realisiert werden können. Die Reed-Kontakte bzw. derartig verwendete Sensoren können bei Nutzung von gleichen Reed-Kontakten und gleicher Distanz zum Leiterseil durch den Einsatz von unterschiedlichen Schirmungen für eine Vielzahl von unterschiedlichen Schwellwerten der Impulsströme ausgelegt werden.

Ergänzend besteht die Möglichkeit der partiellen Reduzierung der Schirmung oder des Einbringens einer Öffnung in der Schirmung. Es könnte insofern auch eine gitterartige oder maschenartige Schirmung genutzt werden. Durch diese Maßnahme kann nicht nur eine Richtungscharakteristik realisiert werden. Vielmehr kann auch bei gleicher Geometrie der Schirmung die Empfindlichkeit beeinflusst werden.

Die Schirmung 18, welche grundsätzlich der Geometrie der einfachen Schirmung 14 entspricht, wurde mit einer partiellen Öffnung versehen, wodurch in der Figur 5 eine Stromschwelle von 20 kA bei einer Distanz von wenigen Millimetern erfassbar ist. Bei Einsatz der einfachen Schirmung ohne Schwächung 14 wäre diese Stromschwelle aufgrund der zu starken Abschirmung gegebenenfalls technisch nicht realisierbar.

Die Wirkung der Schirmung durch ein ferromagnetisches Material beruht hierbei auf der höheren Permeabilität des Schirmmaterials. Die magnetischen Feldlinien werden bis zum Erreichen der Sättigung des Materials umgelenkt, wodurch das magnetische Feld im Bereich der Reed-Kontakte stark abgeschwächt und somit ein Schließen der Reed-Kontakte bis zum Erreichen der Sättigung des Schirmes verhindert wird.

Neben der Auswahl des ferromagnetischen Materials bzw. der Kombination derartiger Materialien sowie deren magnetischer Eigenschaften kann die Wirkung der Schirmung durch die Geometrie und die Positionierung des Reed-Kontaktes in der Schirmung beeinflusst werden.

Es ergibt sich hierdurch eine Vielzahl von Möglichkeiten, um die Schirmung zur Nutzung von Reed-Kontakten an die Aufgabe der Erfassung und Bewertung von Langzeitströmen bzw. Impulsströmen bei kompakten Geräten oder Anordnungen zu nutzen.

## Patentansprüche

1. Vorrichtung zur Erfassung elektrischer Ströme an oder in der Nähe elektrischer Leiter (8) mit mindestens einem Reed-Kontakt (4; 5; 6; 9) als magnetisch ansprechender Schalter, welcher so in der Nähe des elektrischen Leiters (8) angeordnet ist, dass bei einem signifikanten Stromfluss durch den elektrischen Leiter (8) das entstehende magnetische Feld den Schalter auslöst und eine mit dem Schalter in Verbindung stehende Auswerteelektronik anstößt,

   wobei
   für eine Detektion von Stoßstromgrößen und Unterscheidung von Langzeitimpulsströmen einerseits und Kurzzeitimpulsströmen andererseits eine Vielzahl von Reed-Kontakten (4; 5; 6; 9) in vorgegebenem Abstand zum elektrischen Leiter (8) angeordnet sind,
   wobei die Auswerteelektronik (2) das Ansprechen und die Schaltzeiten der jeweiligen Reed-Kontakte (4; 5; 6; 9) ermittelt, aus der Zuordnung der ermittelten Werte zu dem jeweiligen Reed-Kontakt (4; 5; 6; 9) die Stoßstromgröße und aus der Schaltzeit die Impulsform bestimmt wird,
   **dadurch gekennzeichnet, dass**
   für die Einstellung des Ansprechverhaltens wenigstens einer der Reed-Kontakte (4; 5; 6; 9) eine Schirmung (14; 16; 17; 18) zur Beeinflussung des auf den jeweiligen Reed-Kontakt (4; 5; 6; 9) einwirkenden magnetischen Feldes (B) aufweist, wobei die Schirmung (14; 16; 17; 18) ein Schließen des wenigstens einen Reed-Kontakts (14; 16; 17; 18) bis zum Erreichen der Sättigung der Schirmung (14; 16; 17; 18) verhindert.

2. Vorrichtung nach Anspruch 1, **dadurch gekennzeichnet, dass** der elektrische Leiter (8) Bestandteil einer Blitzstromableitung oder einer Fangstange ist.

3. Vorrichtung nach Anspruch 1, **dadurch gekennzeichnet, dass** der elektrische Leiter (8) Bestandteil eines stoßstromführenden Überspannungsableiters ist.

4. Vorrichtung nach einem der vorangegangenen Ansprüche, **dadurch gekennzeichnet, dass** die Auswerteelektronik (2) einen Mikrocontroller (100) und mindestens ein Tiefpassfilter (90) aufweist.

5. Vorrichtung nach Anspruch 4, **dadurch gekennzeichnet, dass** die Daten drahtlos oder drahtgebunden an eine übergeordnete Einheit zur Langzeitanalyse von impulsförmigen Stoßströmen übergeben werden.

6. Vorrichtung nach Anspruch 4 oder 5, **dadurch gekennzeichnet, dass** ein Funkmodul (111; 140) zur Datenübertragung vorgesehen ist, wobei die Datenübertragung erst nach Ablauf einer vorbestimmten Zeitspanne nach Abklingen des letzten Stoßstromimpulses ausgelöst wird.

7. Vorrichtung nach einem der vorangegangenen Ansprüche, **dadurch gekennzeichnet, dass** diese eine autarke Langzeitstromversorgung (3; 50) aufweist.

8. Vorrichtung nach einem der vorangegangenen Ansprüche, **dadurch gekennzeichnet, dass** mindestens die Reed-Kontakte (4; 5; 6; 9) auf einem flächigen Verdrahtungsträger fixiert sind.

9. Vorrichtung nach Anspruch 8, **dadurch gekennzeichnet, dass** die Winkellage der Gruppen von Reed-Kontakten (4; 5; 6; 9) bezogen auf den elektrischen Leiter (8) fest vorgegeben ist.

10. Vorrichtung nach einem der vorangegangenen Ansprüche, **dadurch gekennzeichnet, dass** ein die Komponenten der Vorrichtung aufnehmendes Gehäuse ausgebildet ist, welches eine Stirn- oder Seitenfläche besitzt, die mit Mitteln zur Kennzeichnung der Lage und/oder Befestigung des elektrischen Leiters (8) versehen ist.

11. Vorrichtung nach einem der vorangegangenen Ansprüche, **dadurch gekennzeichnet, dass** diese jeweils an oder in der Nähe von Blitzableiterseilen von Rotorblättern in Windkraftanlagen angeordnet ist.

12. Vorrichtung nach einem der vorangegangenen Ansprüche, **dadurch gekennzeichnet, dass** nach Ablauf einer vorbestimmten oder einstellbaren Zeitspanne zwischen Impulsereignis und Datenweitergabe ein Zeitstempel generierbar ist.

13. Vorrichtung nach einem der vorangegangenen Ansprüche, **dadurch gekennzeichnet, dass** der elektrische Leiter (8) Bestandteil von nicht Blitzstrom führenden Bauteilen oder Einrichtungen, insbesondere von Förderseilen oder Tragseilen von Seilbahnen oder Kränen ist.

14. Verwendung einer Vorrichtung nach einem oder mehreren der Ansprüche 1 bis 11 zur Erfassung und Klassifizierung von Blitz- und Überstromereignissen mit Stoßstromcharakter im Bereich von < 50 A bis 200 kA und Impulsformen als Langzeitimpuls mit T ≥ 10 ms sowie Impulsformen 10/350 μs und 8/20 μs.

**Claims**

1. A device for detecting electrical currents on or in the vicinity of electrical conductors (8) with at least one reed contact (4; 5; 6; 9) as a magnetically responsive switch, which is arranged in the vicinity of the electrical conductor (8) such that, when there is a significant current flow through the electrical conductor (8), the developing magnetic field triggers the switch and initiates an evaluation electronics connected to the switch,

   wherein for detecting surge current variables and differentiating long-term pulse currents, on the one hand, and short-time pulse currents, on the other, a plurality of reed contacts (4; 5; 6; 9) is arranged in a predefined distance from the electrical conductor (8),
   wherein the evaluation electronics (2) determines the response and the switching times of the respective reed contacts (4; 5; 6; 9), from the allocation of the determined values to the respective reed contact (4; 5; 6; 9), the surge current variable is detected, and from the switching time, the pulse shape is detected,
   **characterized in that**
   for setting the response behavior, at least one of the reed contacts (4; 5; 6; 9) has a shield (14; 16; 17; 18) for influencing the magnetic field (B) acting upon the respective reed contact (4; 5; 6; 9), wherein the shield (14; 16; 17; 18) prevents a closing of the at least one reed contact (4; 5; 6; 9) until the saturation of the shield (14; 16; 17; 18) is reached.

2. The device according to claim 1, **characterized in that** the electrical conductor (8) is an integral part of a lightning current arresting system or an arrester rod.

3. The device according to claim 1, **characterized in**

17 **EP 3 775 941 B1** 18

**that** the electrical conductor (8) is an integral part of a surge current-carrying overvoltage arrester.

4. The device according to any one of the preceding claims, **characterized in that** the evaluation electronics (2) has a microcontroller (100) and at least one low-pass filter (90).

5. The device according to claim 4, **characterized in that** the data is transferred in a wireless or wired manner to a superordinate unit for long-term analysis of pulse-shaped surge currents.

6. The device according to claim 4 or 5, **characterized in that** a radio module (111; 140) is provided for data transmission, wherein the data transmission is only triggered after expiration of a predetermined period of time after the last surge current pulse has decayed.

7. The device according to any one of the preceding claims, **characterized in that** it has an autonomous long-term current supply (3; 50).

8. The device according to any one of the preceding claims, **characterized in that** at least the reed contacts (4; 5; 6; 9) are fixed on a planar wiring carrier.

9. The device according to claim 8, **characterized in that** the angular position of the groups of reed contacts (4; 5; 6; 9) with respect to the electrical conductor (8) is fixedly predefined.

10. The device according to any one of the preceding claims, **characterized in that** a housing accommodating the components of the device is formed, which housing has a front or side surface provided with means for identifying the position of and/or attaching the electrical conductor (8).

11. The device according to any one of the preceding claims, **characterized in that** it is in each case arranged on or in the vicinity of lightning arrester cables of rotor blades in wind turbines.

12. The device according to any one of the preceding claims, **characterized in that** after expiration of a predetermined or settable period of time between the pulse event and data transferal, a time stamp can be generated.

13. The device according to any one of the preceding claims, **characterized in that** the electrical conductor (8) is an integral part of constructional parts or facilities that do not carry lightning current, in particular of hoisting cables or carrier cables of cableways or cranes.

14. Use of a device according to one or more of claims 1 to 11 for detecting and classifying lightning current and overcurrent events having a surge current character in the range from < 50 A to 200 kA and pulse shapes as a long-term pulse with T ≥ 10 ms as well as pulse shapes of 10/350 μs and 8/20 μs.

**Revendications**

1. Dispositif de détection de courants électriques sur ou à proximité de conducteurs électriques (8) avec au moins un contact Reed (4 ; 5 ; 6 ; 9) en tant qu'interrupteur à réponse magnétique, qui est disposé à proximité du conducteur électrique (8) de telle sorte que, lors d'un passage significatif de courant à travers le conducteur électrique (8), le champ magnétique généré déclenche l'interrupteur et déclenche une électronique d'évaluation en liaison avec l'interrupteur,

où une pluralité de contacts Reed (4 ; 5 ; 6 ; 9) sont disposés à une distance prédéfinie du conducteur électrique (8) pour une détection des grandeurs de courant de choc et une différenciation des courants d'impulsion de longue durée d'une part et des courants d'impulsion de courte durée d'autre part,
l'électronique d'évaluation (2) déterminant la réponse et les temps de commutation des contacts Reed respectifs (4 ; 5 ; 6 ; 9), la grandeur du courant de choc étant déterminée à partir de l'affectation des valeurs déterminées au contact Reed respectif (4 ; 5 ; 6 ; 9) et la forme d'impulsion étant déterminée à partir du temps de commutation,
**caractérisé en ce que**
pour le réglage du comportement de réponse, au moins l'un des contacts Reed (4 ; 5 ; 6 ; 9) présente un blindage (14 ; 16 ; 17 ; 18) pour influencer le champ magnétique (B) agissant sur le contact Reed respectif (4 ; 5 ; 6 ; 9), le blindage (14 ; 16 ; 17 ; 18) empêchant une fermeture du au moins un contact Reed (14 ; 16 ; 17 ; 18) jusqu'à ce que la saturation du blindage (14 ; 16 ; 17 ; 18) soit atteinte.

2. Dispositif selon la revendication 1, **caractérisé en ce que** le conducteur électrique (8) fait partie d'un paratonnerre ou d'une barre de capture.

3. Dispositif selon la revendication 1, **caractérisé en ce que** le conducteur électrique (8) fait partie d'un parafoudre conduisant le courant de choc.

4. Dispositif selon l'une des revendications précédentes, **caractérisé en ce que** l'électronique d'évaluation (2) comporte un microcontrôleur (100) et au moins un filtre passe-bas (90).

**5.** Dispositif selon la revendication 4, **caractérisé en ce que** les données sont transmises sans fil ou par fil à une unité supérieure pour l'analyse à long terme de courants de choc impulsionnels.

**6.** Dispositif selon la revendication 4 ou 5, **caractérisé en ce qu'**un module radio (111 ; 140) est prévu pour la transmission de données, la transmission de données n'étant déclenchée qu'après l'écoulement d'un laps de temps prédéterminé après la disparition de la dernière impulsion de courant de choc.

**7.** Dispositif selon l'une des revendications précédentes, **caractérisé en ce qu'**il comporte une alimentation électrique autonome de longue durée (3 ; 50).

**8.** Dispositif selon l'une des revendications précédentes, **caractérisé en ce qu'**au moins les contacts Reed (4 ; 5 ; 6 ; 9) sont fixés sur un support de câblage plat.

**9.** Dispositif selon la revendication 8, **caractérisé en ce que** la position angulaire des groupes de contacts Reed (4 ; 5 ; 6 ; 9) par rapport au conducteur électrique (8) est prédéfinie de manière fixe.

**10.** Dispositif selon l'une des revendications précédentes, **caractérisé en ce qu'**un boîtier recevant les composants du dispositif est réalisé, lequel possède une face frontale ou latérale qui est pourvue de moyens de marquage de la position et/ou de la fixation du conducteur électrique (8).

**11.** Dispositif selon l'une des revendications précédentes, **caractérisé en ce qu'**il est disposé respectivement sur ou à proximité de câbles de paratonnerre de pales de rotor dans des installations éoliennes.

**12.** Dispositif selon l'une des revendications précédentes, **caractérisé en ce qu'**un horodatage peut être généré après l'écoulement d'un laps de temps prédéterminé ou réglable entre l'événement d'impulsion et la transmission des données.

**13.** Dispositif selon l'une des revendications précédentes, **caractérisé en ce que** le conducteur électrique (8) fait partie de composants ou de dispositifs ne conduisant pas le courant de foudre, notamment de câbles de transport ou de câbles porteurs de téléphériques ou de grues.

**14.** Utilisation d'un dispositif selon une ou plusieurs des revendications 1 à 11 pour la détection et la classification d'événements de foudre et de surintensité à caractère de courant de choc dans la plage de < 50 A à 200 kA et de formes d'impulsion sous forme d'impulsion de longue durée avec $T \geq 10$ ms ainsi que de formes d'impulsion 10/350 $\mu$s et 8/20 $\mu$s.

Fig. 1

EP 3 775 941 B1

*Fig. 2*

Fig. 3

Fig. 4

EP 3 775 941 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2826247 C2
- DE 10329223 B9
- DE 2700995 A1
- DE 19930089 A1
- DE 19733268 A1
- WO 2017036793 A
- DE 102010038856 A1
- DE 4430382 A1
- RU 2544282 C1